(19) Europäisches Patentamt / European Patent Office / Office européen des brevets

(11) **EP 2 682 712 A1**

(12) **EUROPEAN PATENT APPLICATION**
published in accordance with Art. 153(4) EPC

(43) Date of publication:
**08.01.2014 Bulletin 2014/02**

(51) Int Cl.:
**G01B 11/24** (2006.01)    **G01N 21/21** (2006.01)
**H01L 31/04** (2006.01)

(21) Application number: **11859710.3**

(22) Date of filing: **28.09.2011**

(86) International application number:
**PCT/JP2011/072220**

(87) International publication number:
**WO 2012/117603 (07.09.2012 Gazette 2012/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.03.2011 JP 2011045941**

(71) Applicant: **Dainippon Screen Mfg. Co., Ltd.
Kyoto 602-8585 (JP)**

(72) Inventors:
• **FUJIWARA, Hiroyuki
Gifu-shi
Gifu 501-1193 (JP)**
• **YAMAGUCHI, Shinji
Kyoto-shi
Kyoto 602-8585 (JP)**
• **SUGIMOTO, Yoshio
Kyoto-shi
Kyoto 602-8585 (JP)**

(74) Representative: **Kilian Kilian & Partner
Aidenbachstraße 54
81379 München (DE)**

(54) **FILM-SHAPE ACQUISITION DEVICE AND FILM-SHAPE ACQUISITION METHOD**

(57) In a film shape acquiring apparatus (1), an optical model (8) of a silicon film (86) formed on a substrate (9) having a plurality of texture convexities (870) on a top surface (871) is configured to have thin-film concavities (865) corresponding to the texture convexities (870) and thin-film convexities (860) located thereabove. Each parameter included in a group of parameters representing the shapes of each thin-film convexity (860), each thin-film concavity (865), an intermediate portion between each thin-film convexity (860) and each thin-film concavity (865) is represented by an effective film thickness, and the values of the parameters are changed by changing the effective film thickness so that theoretical spectra are fitted to measured spectra. The shape of the silicon film (86) can thus be acquired with ease and high accuracy.

*FIG. 1*

EP 2 682 712 A1

## Description

## Technical Field

The present invention relates to a technique for acquiring the shape of a thin film formed on a textured top surface of an object.

## Background Art

With increasing attention to global environmental issues in recent years, solar cells that utilize clean sunlight have been developed, and in particular, thin-film silicon solar cells that allow an increase in surface area and a reduction in cost are gathering attention as next-generation solar cells. In the manufacture of thin-film silicon solar cells, a silicon film is formed on a glass substrate by chemical vapor deposition (CVD) or the like.

A technique for improving the conversion efficiency of thin-film silicon solar cells is known in which the surface of a transparent conductive film for use as an electrode on the light incident side is textured (uneven), thus trapping the incident light in a solar cell. The surface of a silicon film formed on such a transparent conductive film is textured due to the influence of the surface shape of the transparent conductive film.

Japanese Patent Application Laid Open No. 2004-157060 proposes a technique for measuring a change in the condition of an interface between two contiguous thin films in a multi-layer thin-film laminate due to unevenness of the interface and material mixing in the vicinity of the interface. In the measurement method of Japanese Patent Application Laid-Open No. 2004-157060, when structural analysis using fitting is performed on the interface of an object to be measured, the fitting is performed for a model of a plurality of layers divided at the interface and for a model of a single layer that ignores the interface. If a difference in fitting precision between the two models is small, it is determined that disturbance at the interface is large (i.e., the degree of unevenness of the interface is large, or the degree of the material mixing in the vicinity of the interface is large). If the difference in the fitting precision is large, it is determined that the disturbance at the interface is small.

Meanwhile, performing ellipsometry analysis on a silicon film formed on a textured transparent conductive film requires a large number of parameters for representing the shapes of the top and bottom surfaces of the silicon film. The shape of the top surface of the silicon film is different from that of the bottom surface and also varies depending on the film thickness of the silicon film. Thus, precisely determining the shapes of the top and bottom surfaces of the silicon film when performing ellipsometry analysis on the silicon film considerably increases the number of parameters to be analyzed, making it difficult to precisely determine the optical characteristics of the silicon film.

## Summary of Invention

The present invention is intended for a film shape acquiring apparatus for acquiring the shape of a thin film formed on a textured top surface of an object, and it is an object of the invention to acquire the shape of the thin film with ease and high accuracy.

A film shape acquiring apparatus according to the present invention includes a spectroscopic ellipsometer, and a calculation part for acquiring measured spectra through measurement of the thin film using the spectroscopic ellipsometer, and fitting theoretical spectra determined from an optical model of the thin film to the measured spectra by changing values of a group of parameters representing the shape of the thin film so as to determine an effective film thickness that is an average film thickness of the thin film and values of the group of parameters, wherein in the optical model of the thin film, a film top surface that is a top surface of the thin film has a plurality of thin-film convexities corresponding to a plurality of texture convexities of the top surface of the object, and a film bottom surface that is a bottom surface of the thin film has a plurality of thin-film concavities corresponding to the plurality of texture convexities, the plurality of texture convexities include a plurality of types of convexities that are distributed at a predetermined ratio, when the top surface of the object is divided into a plurality of unit regions each including the plurality of texture convexities, a shape of the thin film on each unit region includes a plurality of types of shapes corresponding to the plurality of types of convexities, the group of parameters includes at least two parameters selected from: a vertical height of a thin-film convexity on each unit region, a coefficient corresponding to a curvature of the thin-film convexity on each unit region, a volume fraction of an upper end portion of the thin-film convexity on each unit region, a vertical height of a thin-film concavity on each unit region, a coefficient corresponding to a curvature of the thin-film concavity on each unit region, a volume fraction of an upper end portion of the thin-film concavity on each unit region, and a vertical distance between a lower end of the thin-film convexity and an upper end of the thin-film concavity on each unit region, the at least two parameters are represented by the effective film thickness, and the at least two parameters are changed by changing the effective film thickness during the fitting. The film shape acquiring apparatus is capable of acquiring the shape of a thin film formed on an object having a texture structure with ease and high accuracy.

Preferably, the at least two parameters include the vertical height of the thin-film convexity on each unit region, the coefficient corresponding to the curvature of the thin-film convexity on each unit region, and the volume fraction of the upper end portion of the thin-film convexity on each unit region.

In another preferable embodiment, the at least two parameters include the vertical height of the thin-film concavity on each unit region, and the coefficient corresponding to the curvature of the thin-film concavity on each unit region.

In another preferable embodiment, the calculation part performs the fitting using an effective medium theory that includes the volume fraction of the thin-film convexity as a parameter, and an effective medium theory that includes the volume fraction of the thin-film concavity as a parameter.

The present invention is also intended for a film shape acquiring method for acquiring the shape of a thin film formed on a textured top surface of an object. The film shape acquiring method includes a) acquiring measured spectra by measuring the thin film using a spectroscopic ellipsometer, and b) fitting theoretical spectra determined from an optical model of the thin film to the measured spectra by changing values of a group of parameters representing the shape of the thin film so as to determine an effective film thickness that is an average film thickness of the thin film and values of the group of parameters, wherein in the optical model of the thin film, a film top surface that is a top surface of the thin film has a plurality of thin-film convexities corresponding to a plurality of texture convexities of the top surface of the object, and a film bottom surface that is a bottom surface of the thin film has a plurality of thin-film concavities corresponding to the plurality of texture convexities, the plurality of texture convexities include a plurality of types of convexities that are distributed at a predetermined ratio, when the top surface of the object is divided into a plurality of unit regions each including the plurality of texture convexities, a shape of the thin film on each unit region includes a plurality of types of shapes corresponding to the plurality of types of convexities, the group of parameters includes at least two parameters selected from: a vertical height of a thin-film convexity on each unit region, a coefficient corresponding to a curvature of the thin-film convexity on each unit region, a volume fraction of an upper end portion of the thin-film convexity on each unit region, a vertical height of a thin-film concavity on each unit region, a coefficient corresponding to a curvature of the thin-film concavity on each unit region, a volume fraction of an upper end portion of the thin-film concavity on each unit region, and a vertical distance between a lower end of the thin-film convexity and an upper end of the thin-film concavity on each unit region, the at least two parameters are represented by the effective film thickness, and the at least two parameters are changed by changing the effective film thickness during the fitting.

The foregoing and other objects, features, aspects and advantages of the present invention will become more apparent from the following detailed description of the present invention, taken in conjunction with the accompanying drawings.

**Brief Description of Drawings**

Fig. 1 is a perspective view showing a film shape acquiring apparatus;
Fig. 2 shows a configuration of a computer;
Fig. 3 is a block diagram showing a functional configuration implemented by a computer;
Fig. 4A shows an optical model;
Fig. 4B shows an optical model;
Fig. 5 is an enlarged view of a first thin-film convexity;
Fig. 6 shows an optical model;
Fig. 7A is a graph showing the relationship between a parameter and an effective film thickness;
Fig. 7B is a graph showing the relationship between a parameter and the effective film thickness;
Fig. 7C is a graph showing the relationship between a parameter and the effective film thickness;
Fig. 7D is a graph showing the relationship between a parameter and the effective film thickness;
Fig. 7E is a graph showing the relationship between a parameter and the effective film thickness;
Fig. 7F is a graph showing the relationship between a parameter and the effective film thickness;
Fig. 7G is a graph showing the relationship between a parameter and the effective film thickness;
Fig. 7H is a graph showing the relationship between a parameter and the effective film thickness;
Fig. 8 is a flowchart of processing for acquiring the shape of a silicon film; and
Fig. 9 is a graph showing spectra of a silicon film.

**Description of Embodiments**

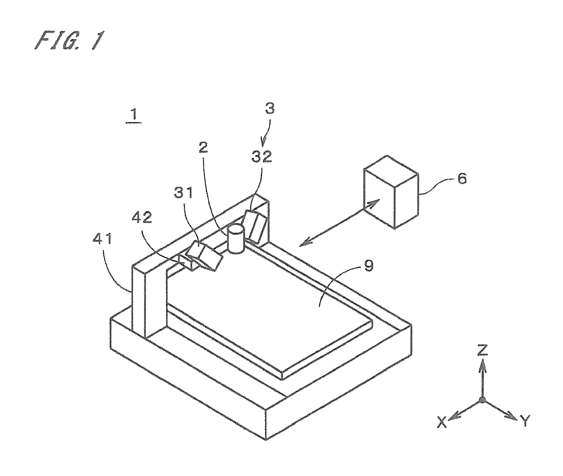

Fig. 1 is a perspective view showing a film shape acquiring apparatus 1 according to an embodiment of the present invention. The film shape acquiring apparatus 1 is an apparatus for acquiring the shape of a thin film formed on the top surface of an object. In the present embodiment, the object is a substrate 9 for thin-film silicon solar cells in which a transparent conductive film is formed on a glass substrate. On the top surface of the substrate 9 is formed an amorphous silicon film (hereinafter simply referred to as a "silicon film") serving as the thin film. The top surface of the transparent conductive film of the substrate 9 is textured (i.e., has a plurality of convexities), and the top and bottom surfaces of the silicon film formed on the transparent conductive film are also textured. With the film shape acquiring apparatus 1, the top and bottom surface shapes, film thickness, and the like of the silicon film are acquired as the shape of the silicon film. The size of the substrate 9 is, for example, 1 to 2 meters (m) square.

The film shape acquiring apparatus 1 includes an imaging part 2 for capturing an image of a surface of the substrate 9, a spectroscopic ellipsometer 3 for acquiring measured spectra described later, a Y-direction moving part 41 capable of moving in the Y direction in Fig. 1, an X-direction moving part 42 capable of moving in the X direction in Fig. 1, and a computer 6 configured by, for example, a CPU that performs various types of computational processing and a memory that stores various types of information. The computer 6 functions as a control part for controlling the constituent elements of the film shape acquiring apparatus 1. The X-direction moving part 42 is provided on the Y-direction moving part 41, and the imaging part 2 and the spectroscopic ellipsometer 3 are fixed to the X-direction moving part 42. The film shape acquiring apparatus 1 allows a position irradiated with light by the spectroscopic ellipsometer 3 to be disposed at any position on the substrate 9 as intended.

The spectroscopic ellipsometer 3 includes an illumination part 31 and a light receiving part 32 that are disposed above the substrate 9 (on the (+Z) side in Fig. 1), the illumination part 31 emitting polarized white light toward the substrate 9, and the light receiving part 32 receiving reflected light from the substrate 9. The light receiving part 32 includes an analyzer that receives reflected light and a spectroscope that acquires the spectral intensity of reflected light, and the rotational position of the analyzer and the spectral intensity of the reflected light acquired by the spectroscope are output to the computer 6. In the computer 6, the phase difference and reflection amplitude ratio angle between p- and s-polarized light components are obtained as a polarized state of each of light rays having a plurality of frequencies (or wavelengths). That is, frequency spectra of the phase difference and the reflection amplitude ratio angle (hereinafter, referred to collectively as "measured spectra") are acquired.

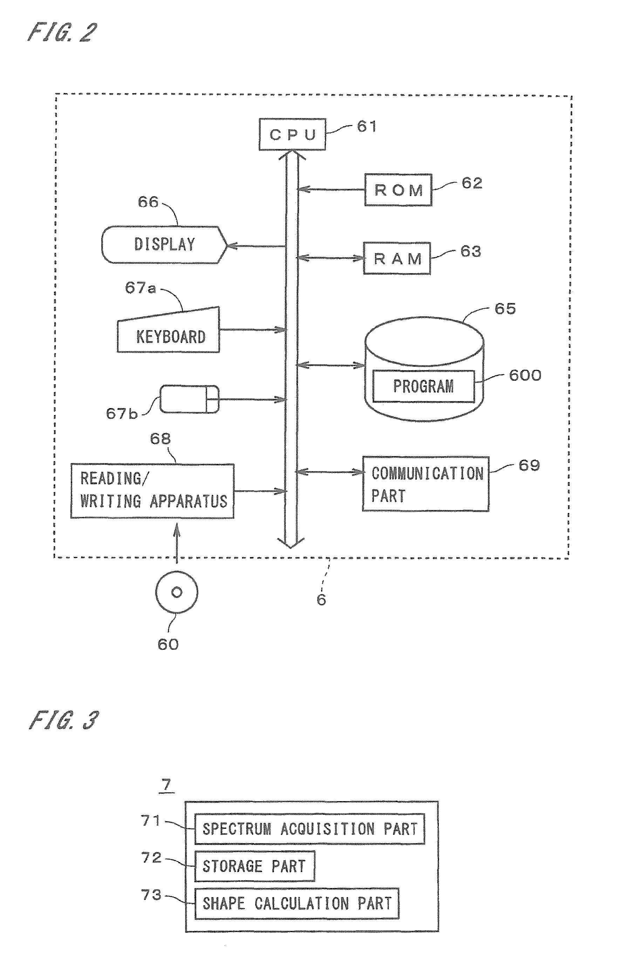

Fig. 2 shows a configuration of the computer 6. The computer 6 is configured as a general computer system in which a CPU 61 that performs various types of computational processing, a ROM 62 that stores a basic program, and a RAM 63 that stores various types of information are connected to a bus line. A fixed disk 65 for information storage, a display 66 that displays various types of information, a keyboard 67a and a mouse 67b that receive input from an operator, a reading/writing apparatus 68 that reads and writes information from and to a computer-readable recording medium 60 such as an optical disk, a magnetic disk, or a magneto-optical disk, and a communication part 69 that performs communication with external devices are further connected to the bus line appropriately via an interface (I/F) or the like.

In the computer 6, a program 600 is read from the recording medium 60 and stored in the fixed disk 65 in advance via the reading/writing apparatus 68. The program 600 is then copied into the RAM 63 and the CPU 61 executes computational processing in accordance with the program 600 stored in the RAM 63 (i.e., the computer executes the program). This allows the computer 6 to perform processing as a calculation part described later.

Fig. 3 is a block diagram showing a functional configuration implemented by, for example, the CPU 61, the ROM 62, the RAM 63, and the fixed disk 65 as a result of the CPU 61 operating in accordance with the program 600. In Fig. 3, a spectrum acquisition part 71 and a shape calculation part 73 of a calculation part 7 represent functions implemented by the CPU 61 and the like, and a storage part 72 represents a function implemented by the fixed disk 65 and the like. Note that the functions of the calculation part 7 may be implemented by a dedicated electrical circuit, or an electrical circuit may be used in part of the calculation part 7.

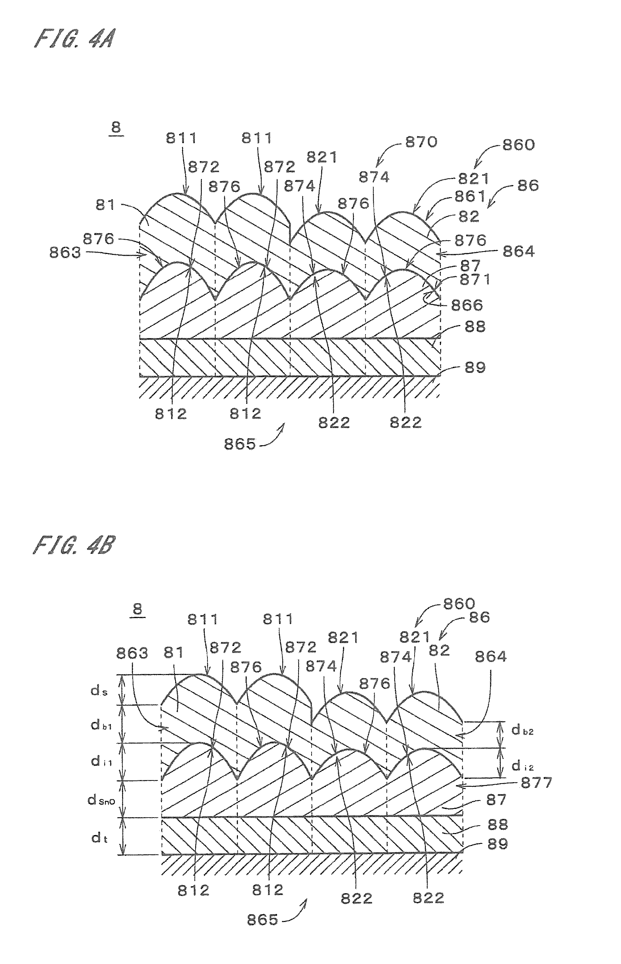

Next, the principle of measurement of the shape of the silicon film performed by the film shape acquiring apparatus 1 will be described. Fig. 4A shows an optical model 8 used for ellipsometry analysis of the silicon film performed by the film shape acquiring apparatus 1. The optical model 8 includes a light-transmitting layer 88 formed on a glass substrate 89, a transparent conductive film 87, and a silicon film 86. The transparent conductive film 87 is modeled as a fluorinated tin oxide ($SnO_2$:F) layer, and the silicon film 86 is modeled as an amorphous silicon hydride (a-Si:H) layer.

The transparent conductive film 87 has a textured top surface 871 in which a plurality of texture convexities 870 are set. In the case of an actual textured transparent conductive film, texture size is not uniform at each position on the top surface. To represent the nonuniformity of the texture size of the transparent conductive film 87 in the optical model 8, a first region in which a plurality of first texture convexities 872 are distributed and a second region in which a plurality of second texture convexities 874 lower in height than the first texture convexities 872 are distributed are set in the top surface 871 of the transparent conductive film 87. The ratios of the areas of the first region and the second region to the overall area of the top surface 871 are each 50%. In other words, the plurality of texture convexities 870 of the top surface 871 of the transparent conductive film 87 include a plurality of types of convexities (the first texture convexities 872 and the second texture convexities 874) that are distributed at a predetermined area ratio (50% each).

When the top surface 871 of the transparent conductive film 87 is divided into a plurality of unit regions 876 including texture convexities 870, the first region is a set of a plurality of unit regions 876 corresponding to the plurality of first texture convexities 872, and the second region is a set of a plurality of unit regions 876 corresponding to the plurality of second texture convexity 874.

A plurality of thin-film convexities 860 corresponding to the plurality of texture convexities 870 of the transparent conductive film 87 are set on the respective unit regions 876 in a film top surface 861 that is the top surface of the silicon film 86. A plurality of thin-film concavities 865 corresponding to (matching) the plurality of texture convexities 870 of the transparent conductive film 87 are set on the respective unit regions 876 in a film bottom surface 866 that is the bottom surface of the silicon film 86. The shape of the thin-film concavities 865 is equivalent to the shape of texture convexities 870 that are in contact with the thin-film concavities 865.

In the case of a silicon film formed on an actual textured transparent conductive film, differences in the shapes of the texture convexities of the transparent conductive film result in differences in the shapes of portions formed on the texture convexities. The optical model 8 is thus configured such that the shape of the silicon film 86 on each unit region 876, or in other words, the shape of a portion between the opposing thin-film convexity 860 and thin-film concavity 865 on the unit region 876 includes a plurality of types of shapes corresponding to the plurality of types of convexities of the texture convexities 870. In the following description, a portion of the silicon film 86 on a first texture convexity 872 is referred to as a "first portion 81," and a thin-film convexity 860 of the top surface of the first portion 81 and a thin-film concavity 865 of the bottom surface of the first portion 81 are respectively referred to as a "first thin-film convexity 811" and a "first thin-film concavity 812." Meanwhile, a portion of the silicon film 86 on a second texture convexity 874 is referred to as a "second portion 82," and a thin-film convexity 860 of the top surface of the second portion 82 and a thin-film concavity 865 of the bottom surface of the second portion 82 are respectively referred to as a "second thin-film convexity 821" and a "second thin-film concavity 822."

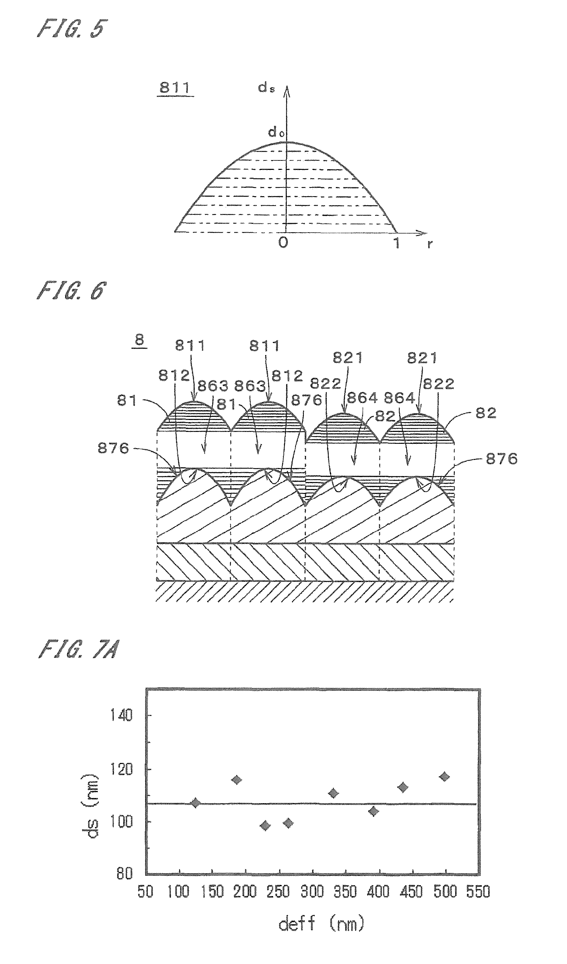

Fig. 5 is an enlarged view of a first thin-film convexity 811. In the optical model 8, if do is the vertical height (thickness) of the first thin-film convexity 811, the maximum half-width is 1, and $\alpha_1$ is a coefficient (a coefficient that indicates an inclination in the direction away from the upper end of the first thin-film convexity 811 and is hereinafter referred to as a "curvature coefficient") corresponding to the curvature, a height $d_s$ (r) of the first thin-film convexity 811 at a position where the half width is r is represented by Eq. 1.

$$[\text{Eq. 1}]$$

$$d_s\left(r\right) = d_o\left(1 - r^{\alpha 1}\right)$$

As indicated by the double-dotted chain line in Fig. 5, the curvature coefficient $\alpha_1$ can also be understood to represent a change in the volume fraction of the amorphous silicon hydride (hereinafter simply referred to as "silicon") in each layer of the first thin-film convexity 811 when the first thin-film convexity 811 is divided vertically into a plurality of layers. In addition to the height $d_s$ and the curvature coefficient $\alpha_1$ described above, a volume fraction $\beta$ of air in the uppermost layer (i.e., the upper end portion) of the first thin-film convexity 811 when the first thin-film convexity 811 is divided vertically into ten layers is set as a parameter representing the shape of the first thin-film convexity 811. The volume fraction $\beta$ can also be understood to be a parameter representing a volume fraction of silicon in the upper end portion of the first thin-film convexity 811.

In the optical model 8 shown in Fig. 4A, the shapes of each second thin-film convexity 821, each first texture convexity 872, and each second texture convexity 874 are also represented in the same manner as with each first thin-film convexity 811. In the present embodiment, the shape of a second thin-film convexity 821 is represented using the height $d_s$, the curvature coefficient $\alpha_1$, and the volume fraction $\beta$ described above as parameters. In other words, the shape of the second thin-film convexity 821 is assumed to be equal to the shape of the first thin-film convexity 811.

As shown in Fig. 4B, the shape of the first texture convexity 872 (i.e., the shape of the first thin-film concavity 812) is also represented using a vertical height $d_{i1}$ of the first thin-film concavity 812 and a curvature coefficient $\alpha_2$ of the first thin-film concavity 812 as parameters. The shape of the second texture convexity 874 (i.e., the shape of the second thin-film concavity 822) is represented using a vertical height $d_{i2}$ of the second thin-film concavity 822 and the curvature coefficient $\alpha_2$ described above as parameters. In other words, the first thin-film concavity 812 and the second thin-film concavity 822 are assumed to have different vertical heights and the same curvature coefficient.

Furthermore, in the optical model 8, a vertical distance between the lower end of the first thin-film convexity 811 of the first portion 81 and the upper end of the first thin-film concavity 812 of the first portion 81, or in other words, a height $d_{b1}$ of an intermediate portion 863 in which only the silicon film 86 is present and substantially no transparent conductive film 87 or air is present at each vertical position, is used as a parameter representing the shape of the first portion 81 of the silicon film 86. Likewise, the shape of the second portion 82 of the silicon film 86 is represented using a height $d_{b2}$ of an intermediate portion 864 of the second portion 82 as a parameter.

As described above, in the optical model 8, the vertical height $d_s$ of the thin-film convexity 860 (i.e., the first thin-film convexity 811 and the second thin-film convexity 821) on each unit region 876, the curvature coefficient $\alpha_1$ of the thin-film convexity 860, the volume fraction $\beta$ of air at the upper end portion of the thin-film convexity 860, the vertical height of the thin-film concavity 865 (i.e., the height $d_{i1}$ of the first thin-film concavity 812 and the height $d_{i2}$ of the second thin-film concavity 822), the curvature coefficient $\alpha_2$ of the thin-film concavity 865, and the vertical distance between the lower end of the thin-film convexity 860 and the upper end of the thin-film concavity 865 (i.e., the height $d_{b1}$ of the intermediate portion 863 of the first portion 81 and the height $d_{b2}$ of the intermediate portion 864 of the second portion 82) are used as a group of parameters representing the shape of the silicon film 86. Additionally, a vertical height $d_{SnO}$ of a lower portion 877 of the transparent conductive film 87, excluding the first texture convexity 872 and the second texture convexity 874, and a vertical height $d_t$ of the light-transmitting layer 88 are also used as parameters.

In the optical model 8, a space having the height

$d_s$ and in which a first thin-film convexity 811 is present on each unit region 876 is divided vertically into ten layers as shown in Fig. 6, and the effective medium theory (e.g., effective medium approximation) is applied to each layer, assuming that the layer is a mixed layer of silicon and air. Likewise, a space having the height $d_s$ and in which a second thin-film convexity 821 is present on each unit region 876 is also assumed to be a mixed layer of silicon and air and is modeled by application of the effective medium theory. A space in which the first thin-film convexities 811 and the second thin-film convexities 821 are present is represented as a model in which the silicon volume fraction increases and the air volume fraction decreases as the distance to the bottom decreases.

A space having the height $d_{i1}$ and in which a first thin-film concavity 812 is present on the unit region 876 is divided vertically into nine layers. Each of the layers is assumed to be a mixed layer of silicon and fluorinated tin oxide (hereinafter simply referred to as "tin oxide") and is modeled by application of the effective medium theory. A space having the height $d_{i2}$ and in which a second thin-film concavity 822 is present on the unit region 876 is also divided vertically into nine layers. Each of the layers is assumed to be a mixed layer of silicon and tin oxide and is modeled by application of the effective medium theory. A space in which the first thin-film concavities 812 and the second thin-film concavities 822 are present is represented as a model in which the silicon volume fraction decreases and the tin oxide volume fraction increases as the distance to the bottom decreases.

The intermediate portion 863 of the first portion 81 of the silicon film 86 and the intermediate portion 864 of the second portion 82 of the silicon film 86 are each modeled as a single silicon layer. In this way, the silicon film 86 of the optical model 8 is represented as a model in which the silicon film 86 on each unit region 876 is divided vertically into 20 layers.

In the film shape acquiring apparatus 1, as preliminary processing for measurement of a silicon film to be measured, a plurality of samples in which a silicon film is formed on a textured transparent conductive film are prepared, and are measured using the spectroscopic ellipsometer 3 so as to acquire measured spectra. The transparent conductive films of the samples are formed so as to have top surfaces of the same shape, and the silicon films are formed to have different thicknesses (i.e., amounts of deposition). Subsequently, fitting of theoretical spectra of the optical model 8 to the measured spectra obtained with the spectroscopic ellipsometer 3 are performed while the above-described group of parameters representing the shape of the silicon film 86, the vertical height $d_{SnO}$ of the lower portion 877 of the transparent conductive film 87, and the vertical height $d_t$ of the light-transmitting layer 88 are being changed in the optical model 8.

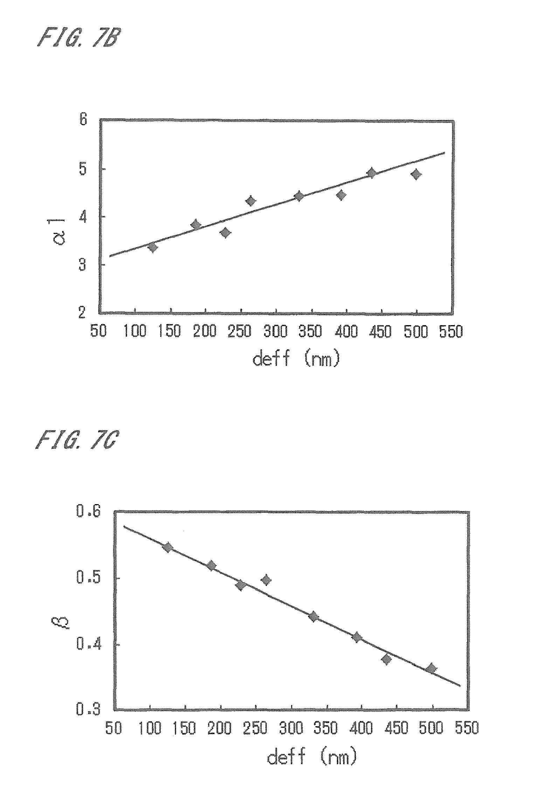

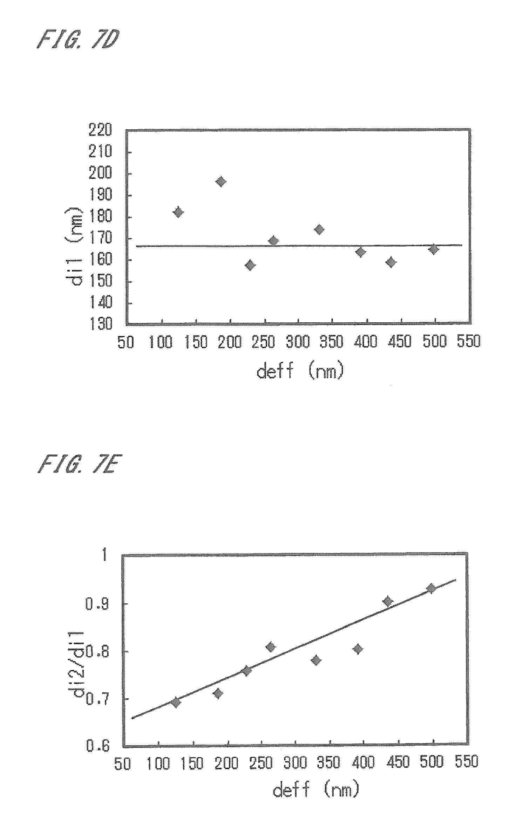

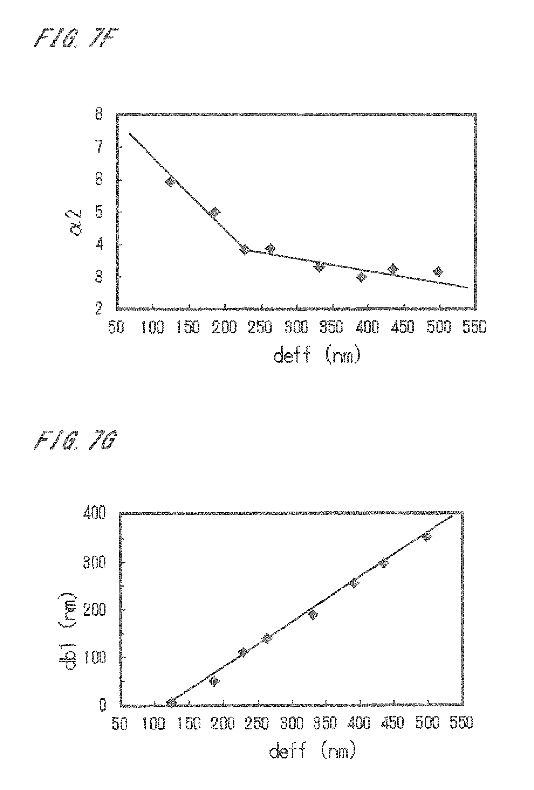

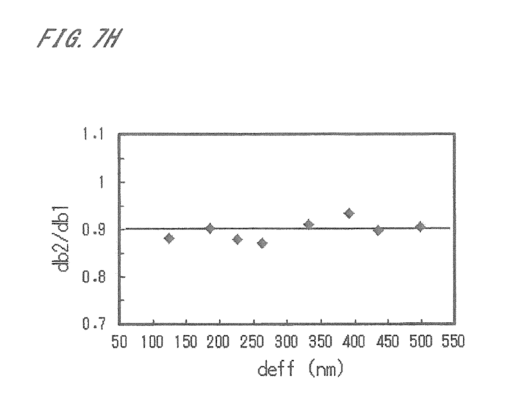

Figs. 7A to 7H are graphs each showing the values of each parameter in the group of parameters representing the shape of the silicon film 86, determined by the fitting performed for the plurality of samples. The horizontal axes in Figs. 7A to 7H indicate an effective film thickness $d_{eff}$ of the silicon film 86 in each sample. The effective film thickness $d_{eff}$ is an average film thickness of the entire silicon film 86 and is obtained by Eqs. 2 and 3.

$$[\text{Eq. 2}]$$

$$d_{eff} = \sum_{k}^{2} A_k \cdot B_k$$

$$[\text{Eq. 3}]$$

$$B = \sum_{j}^{20} d_j \cdot f_{a-Si:Hj}$$

In Eq. 2, $A_k$ (k = 1 to 2) represents the distribution ratio of each of the first thin-film convexities 811 and the second thin-film convexities 821 of the film top surface 861 of the silicon film 86, and the distribution ratio is equal to the area ratio of each of the first region and the second region on the top surface 871 of the transparent conductive film 87. In Eq. 3, $d_j$ (j = 1 to 20) represents the vertical height of each layer of the silicon film 86 that have been divided vertically into 20 layers on each of the first and second regions, and $f_{a-Si:Hj}$ represents the silicon volume fraction in each layer.

The vertical axes in Figs. 7A to 7H respectively represent the height $d_s$ of the thin-film convexity 860 on each unit region 876, the curvature coefficient $\alpha_1$ of the thin-film convexity 860 on the unit region 876, the air volume fraction $\beta$ in the upper end portion of the thin-film convexity 860 on the unit region 876, the height $d_{i1}$ of the first thin-film concavity 812 on the unit region 876, the ratio $d_{i2}/d_{i1}$ of the height $d_{i2}$ of the second thin-film concavity 822 to the height $d_{i1}$ of the first thin-film concavity 812, the curvature coefficient $\alpha_2$ of the thin-film concavity 865 on the unit region 876, the height $d_{b1}$ of the intermediate portion 863 of the first portion 81 on the unit region 876, and the ratio $d_{b2}/d_{b1}$ of the height $d_{b2}$ of the intermediate portion 864 of the second portion 82 to the height $d_{b1}$ of the intermediate portion 863 of the first portion 81. In the film shape acquiring apparatus 1, the parameters representing the shape of the silicon film 86 are each represented as a function of the effective film thickness $d_{eff}$ on the basis of the relationships shown in Figs. 7A to 7H and stored in the storage part 72. In Figs. 7A to 7H, the functions stored in the storage part 72 are indicated by solid lines. The relationship between the effective film thickness $d_{eff}$ and each of the parameters representing the shape of the silicon film 86 may be stored in, for example, a table format in the storage part 72. Note that the ratio $d_{i2}/d_{i1}$ shown in Fig. 7E, which is actually supposed to be constant, is not constant. This is considered to be due to an error resulting from, for example, a slight difference in the top surface shape among the plurality of samples.

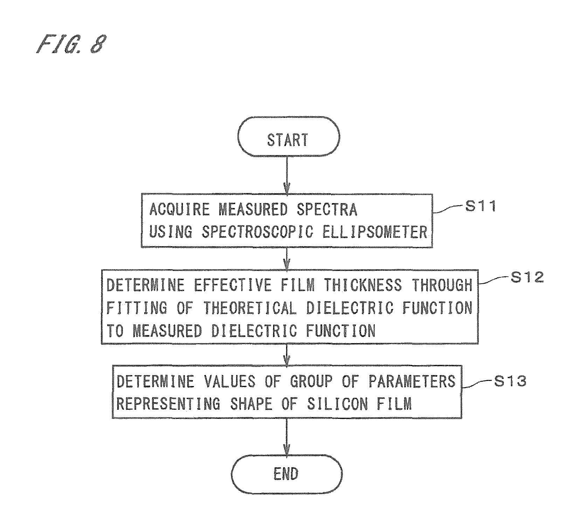

Fig. 8 is a flowchart of the processing for acquiring the shape of a silicon film on the substrate 9. When the substrate 9 on which a silicon film of an unknown shape is transported into the film shape acquiring apparatus 1, predetermined positions of the silicon film on the substrate 9 are measured using the spectroscopic ellipsometer 3 so as to acquire measured spectra (step S 11) .

Next, the shape calculation part 73 (see Fig. 3) fits the theoretical spectra determined from the optical model 8 to the measured spectra by changing the values of the group of parameters (i.e., the parameters shown in Figs. 7A to 7H) representing the shape of the silicon film 86 in the optical model 8, the vertical height $d_{SnO}$ of the lower portion 877 of the transparent conductive film 87, and the vertical height $d_t$ of the light-transmitting layer 88. In the film shape acquiring apparatus 1, the value of each of the group of parameters represented by the effective film thickness $d_{eff}$ (in the present embodiment, represented as a function of the effective film thickness $d_{eff}$) is changed by changing the effective film thickness $d_{eff}$ of the silicon film 86 during the fitting. Then, the value of the effective film thickness $d_{eff}$ with which the theoretical spectra are most approximate to the measured spectra, the value of the height $d_{SnO}$ of the lower portion 877 of the transparent conductive film 87 with which the theoretical spectra are most approximate to the measured spectra, and the value of the vertical height $d_t$ of the light-transmitting layer 88 with which the theoretical spectra are most approximate to the measured spectra are determined (step S12). At the same time, the values of the parameters in the group of parameters representing the shape of the silicon film 86 are also determined (step S13).

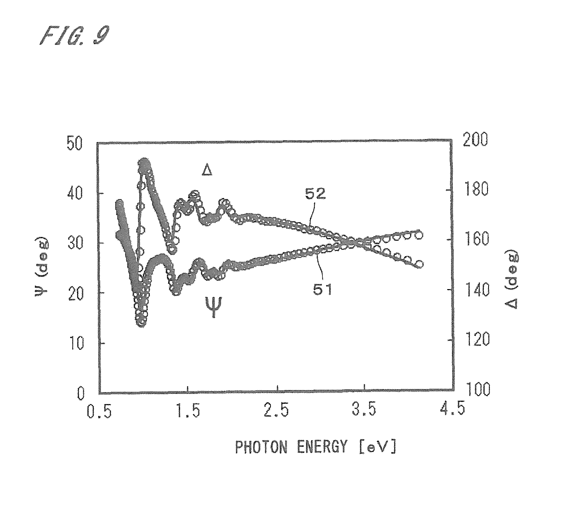

Fig. 9 shows the results of ellipsometry analysis performed for a silicon film on one substrate 9 by the film shape acquiring apparatus 1. The plurality of circles in Fig. 9 indicate $\Psi$ and $\Delta$ (i.e., measured spectra) measured using the spectroscopic ellipsometer 3, and lines 51 and 52 respectively indicate theoretical spectra of $\Psi$ and $\Delta$ determined by the above-described fitting. As shown in Fig. 9, the theoretical spectra relating to the polarized state of the silicon film and determined by the shape calculation part 73 precisely match the measured spectra obtained with the spectroscopic ellipsometer 3, and therefore highly accurate ellipsometry analysis is realized. Table 1 shows the values of the parameters in the group of parameters representing the shape of the silicon film determined by this ellipsometry analysis.

[Table 1]

| d s | 116nm |
|---|---|
| $\alpha$ 1 | 4. 5 |

(continued)

| $\beta$ | 40% |
|---|---|
| d i 1 | 156nm |
| d i 2 | 150nm |
| $\alpha$ 2 | 3. 6 |
| d b 1 | 255nm |
| d b 2 | 226nm |
| d SnO | 632nm |
| d t | 145nm |

In the film shape acquiring apparatus 1, each parameter in the group of parameters representing the shape of the silicon film 86 of the optical model 8 is represented by the effective film thickness $d_{eff}$, and the theoretical spectra are fitted to the measured spectra by changing the effective film thickness $d_{eff}$ so as to change the values of the parameters. This enables the shape of the silicon film to be acquired easily and promptly as compared to the case where fitting is performed by separately changing the parameters in the group of parameters representing the shape of the silicon film 86. In the case of separately changing the above-described parameters, there is a possibility that local solutions may be obtained. In contrast, representing the parameters by the effective film thickness $d_{eff}$ makes it possible to prevent the parameters from assuming local solutions and to acquire the shape of the silicon film with high accuracy.

With the film shape acquiring apparatus 1, not all the above-described parameters in the group of parameters representing the shape of the silicon film 86 have to be represented by the effective film thickness $d_{eff}$. It is sufficient that at least two of the parameters included in the group of parameters be represented by the effective film thickness $d_{eff}$ and be changed by changing the effective film thickness $d_{eff}$ during the fitting in step S 12. This allows the shape of the silicon film to be acquired easily and promptly and with high accuracy.

The shape of a thin-film convexity can be acquired with higher accuracy if the group of parameters includes the vertical height of the thin-film convexity 860, the curvature coefficient of the thin-film convexity 860, and the volume fraction of the upper end portion of the thin-film convexity 860 (which may be substantially a parameter indicating the aforementioned volume fraction) as parameters represented by the effective film thickness $d_{eff}$, and these parameters are changed by changing the effective film thickness $d_{eff}$ during the fitting in step S 12. Also, the shape of a thin-film concavity can be acquired with higher accuracy if the group of parameters includes the vertical height of the thin-film concavity 865 and the curvature coefficient of the thin-film concavity 865 as parameters represented by the effective film thickness $d_{eff}$, and these parameters are changed by changing the effective film thickness $d_{eff}$ during the fitting in step S 12.

In the film shape acquiring apparatus 1, as described above, the space in which the thin-film convexities 860 are present is assumed to be a mixed layer of silicon and air, and the fitting in step S12 is performed using the effective medium theory that includes the silicon volume fraction (i.e., the volume fraction of silicon within the thin-film convexity 860) as a parameter. This makes it possible to acquire the shape of the thin-film convexity with higher accuracy. The shape of the thin-film convexity can be acquired with even higher accuracy by vertically dividing the space in which the thin-film convexities 860 are present into a plurality of layers and applying the effective medium theory to each layer assuming that the layer is a mixed layer of silicon and air.

In the film shape acquiring apparatus 1, the space in which the thin-film concavities 865 are present is assumed to be a mixed layer of silicon and tin oxide, and the fitting in step S12 is performed using the effective medium theory that includes the silicon volume fraction (i.e., the volume fraction of silicon within the thin-film concavity 865) as a parameter. This makes it possible to acquire the shape of the thin-film concavity with higher accuracy. The shape of the thin-film concavity can be acquired with even higher accuracy by vertically dividing the space in which the thin-film concavities 865 are present into a plurality of layers and applying the effective medium theory to each layer assuming that the layer is a mixed layer of silicon and air.

While the above has been a description of embodiments of the present invention, the present invention is not intended to be limited to the above-described embodiments and can be modified in various ways.

In the case of vertically dividing the thin-film convexity 860 and the thin-film concavity 865 in the optical model 8, the number of layers to be divided is not limited to the above-described number and may be changed as appropriate. In the optical model 8, the texture convexity 870 may include three or more types of convexities of different shapes. In this case, the shape of the silicon film 86 on each unit region 876 also includes three or more shapes.

The silicon film 86 may be configured such that the lower end of each first thin-film convexity 811 is lower than the upper end of each first thin-film concavity 812 and the lower end of each second thin-film convexity 821 is lower than the upper end of the second thin-film concavity 822. In this case, the intermediate portion 863 and the intermediate portion 864 are not present, and in the fitting in step S12, the effective medium theory is applied assuming that the space between the upper portion of the first thin-film concavity 812 and the lower portion of the first thin-film convexity 811 and the space between the upper portion of the second thin-film concavity 822 and the lower portion of the second thin-film convexity 821 are mixed layers of air, silicon, and tin oxide.

With the film shape acquiring apparatus 1, it is possible to acquire the shape of a silicon film formed on a textured top surface of a variety of objects such as a substrate for solar cells other than the above-described substrate 9 and the surfaces of plastic films. The film shape acquiring apparatus 1 may also acquire the shape of a thin film other than a silicon film formed on the textured top surface of an object.

While the invention has been shown and described in detail, the foregoing description is in all aspects illustrative and not restrictive. It is therefore understood that numerous modifications and variations can be devised without departing from the scope of the invention.

**Reference Signs List**

| | |
|---|---|
| 1 | Film shape acquiring apparatus |
| 3 | Spectroscopic ellipsometer |
| 7 | Calculation part |
| 8 | Optical model |
| 9 | Substrate |
| 86 | Silicon film |
| 87 | Transparent conductive film |
| 811 | First thin-film convexity |
| 812 | First thin-film concavity |
| 821 | Second thin-film convexity |
| 822 | Second thin-film concavity |
| 860 | Thin-film convexity |
| 861 | Film top surface |
| 865 | Thin-film concavity |
| 866 | Film bottom surface |
| 870 | Texture convexity |
| 871 | Top surface |
| 872 | First texture convexity |
| 874 | Second texture convexity |
| 876 | Unit region |
| S11 to S13 | Step |

**Claims**

1. A film shape acquiring apparatus (1) for acquiring a shape of a thin film (86) formed on a textured top surface (871) of an object (9), comprising:

a spectroscopic ellipsometer; and
a calculation part (7) for acquiring measured spectra through measurement of said thin film (86) using said spectroscopic ellipsometer, and fitting theoretical spectra determined from an optical model (8) of said thin film (86) to said measured spectra by changing values of a group of parameters representing the shape of said thin film (86) so as to determine an effective film thickness that is an average film thickness of said thin film (86) and values of said group of parameters,
wherein in said optical model (8) of said thin film (86),

a film top surface (861) that is a top surface of said thin film (86) has a plurality of thin-film convexities (860) corresponding to a plurality of texture convexities (870) of said top surface (871) of said object (9), and a film bottom surface (866) that is a bottom surface of said thin film (86) has a plurality of thin-film concavities (865) corresponding to said plurality of texture convexities (870),

said plurality of texture convexities (870) include a plurality of types of convexities (872, 874) that are distributed at a predetermined ratio,

when said top surface (871) of said object (9) is divided into a plurality of unit regions (876) each including said plurality of texture convexities (870), a shape of said thin film (86) on each unit region (876) includes a plurality of types of shapes corresponding to said plurality of types of convexities (872, 874),

said group of parameters includes at least two parameters selected from:

a vertical height of a thin-film convexity (860) on said each unit region (876);

a coefficient corresponding to a curvature of said thin-film convexity (860) on said each unit region (876);

a volume fraction of an upper end portion of said thin-film convexity (860) on said each unit region (876);

a vertical height of a thin-film concavity (865) on said each unit region (876);

a coefficient corresponding to a curvature of said thin-film concavity (865) on said each unit region (876);

a volume fraction of an upper end portion of said thin-film concavity (865) on said each unit region (876); and

a vertical distance between a lower end of said thin-film convexity (860) and an upper end of said thin-film concavity (865) on said each unit region (876),

said at least two parameters are represented by said effective film thickness, and

said at least two parameters are changed by changing said effective film thickness during said fitting.

2. The film shape acquiring apparatus (1) according to claim 1, wherein
said at least two parameters include:

the vertical height of said thin-film convexity (860) on said each unit region (876);

the coefficient corresponding to the curvature of said thin-film convexity (860) on said each unit region (876) ; and

the volume fraction of the upper end portion of said thin-film convexity (860) on said each unit region (876).

3. The film shape acquiring apparatus (1) according to claim 1 or 2, wherein
said at least two parameters include:

the vertical height of said thin-film concavity (865) on said each unit region (876) ; and

the coefficient corresponding to the curvature of said thin-film concavity (865) on said each unit region (876).

4. The film shape acquiring apparatus (1) according to any one of claims 1 to 3, wherein
said calculation part performs said fitting using an effective medium theory that includes the volume fraction of said thin-film convexity (860) as a parameter, and an effective medium theory that includes the volume fraction of said thin-film concavity (865) as a parameter.

5. The film shape acquiring apparatus (1) according to any one of claims 1 to 4, wherein
said object (9) is a substrate for solar cells.

6. A film shape acquiring method for acquiring a shape of a thin film (86) formed on a textured top surface (871) of an object (9), comprising:

a) acquiring measured spectra by measuring said thin film (86) using a spectroscopic ellipsometer; and

b) fitting theoretical spectra determined from an optical model (8) of said thin film (86) to said measured spectra by changing values of a group of parameters representing the shape of said thin film (86) so as to determine an effective film thickness that is an average film thickness of said thin film (86) and values of said group of parameters,

wherein in said optical model (8) of said thin film (86),

a film top surface (861) that is a top surface of said thin film (86) has a plurality of thin-film convexities (860) corresponding to a plurality of texture convexities (870) of said top surface (871) of said object (9), and a film bottom surface (866) that is a bottom surface of said thin film (86) has a plurality of thin-film concavities (865) corresponding to said plurality of texture convexities (870),

said plurality of texture convexities (870) include a plurality of types of convexities (872, 874) that are distributed at a predetermined ratio,

when said top surface (871) of said object (9) is divided into a plurality of unit regions (876) each including said plurality of texture convexities (870), a shape of said thin film (86) on each unit region (876) includes a plurality of types of shapes corresponding to said plurality of types of convexities (872, 874),

said group of parameters includes at least two parameters selected from:

a vertical height of a thin-film convexity (860) on said each unit region (876);

a coefficient corresponding to a curvature of said thin-film convexity (860) on said each unit region (876);

a volume fraction of an upper end portion of said thin-film convexity (860) on said each unit region (876);

a vertical height of a thin-film concavity (865) on said each unit region (876);

a coefficient corresponding to a curvature of said thin-film concavity (865) on said each unit region (876);

a volume fraction of an upper end portion of said thin-film concavity (865) on said each unit region (876); and

a vertical distance between a lower end of said thin-film convexity (860) and an upper end of said thin-film concavity (865) on said each unit region (876),

said at least two parameters are represented by said effective film thickness, and

said at least two parameters are changed by changing said effective film thickness during said fitting.

7. The film shape acquiring method according to claim 6, wherein
said at least two parameters include:

the vertical height of said thin-film convexity (860) on said each unit region (876);

the coefficient corresponding to the curvature of said thin-film convexity (860) on said each unit region (876) ; and

the volume fraction of the upper end portion of said thin-film convexity (860) on said each unit region (876).

8. The film shape acquiring method according to claim 6 or 7, wherein
said at least two parameters include:

the vertical height of said thin-film concavity (865) on said each unit region (876) ; and

the coefficient corresponding to the curvature of said thin-film concavity (865) on said each unit region (876).

9. The film shape acquiring method according to any one of claims 6 to 8, wherein,

in said operation b), said fitting is performed using an effective medium theory that includes the volume fraction of said thin-film convexity (860) as a parameter, and an effective medium theory that includes the volume fraction of said thin-film concavity (865) as a parameter.

10. The film shape acquiring method according to any one of claims 6 to 9, wherein
said object (9) is a substrate for solar cells.

FIG. 1

*FIG. 2*

*FIG. 3*

*FIG. 4A*

8

811 811 870 860

872 872 821 821

876 874 874 86

81 876 876 861

82

876

863 876 864

87

871

866

88

89

812 812 822 822

865

*FIG. 4B*

8 860

811 811 872 821 86

863 81 872 876 872 874 874 821 82 864

$d_s$

$d_{b1}$ 876 876 $d_{b2}$

$d_{i1}$ $d_{i2}$

877

$d_{sn0}$ 87

88

$d_t$ 89

812 812 822 822

865

*FIG. 5*

*FIG. 6*

*FIG. 7A*

FIG. 7B

FIG. 7C

FIG. 7D

FIG. 7E

*FIG. 7F*

*FIG. 7G*

FIG. 7H

*FIG. 8*

```
        ┌─────────────┐
        │    START    │
        └──────┬──────┘
               │
               ▼
┌──────────────────────────────────┐
│ ACQUIRE MEASURED SPECTRA          │──S11
│ USING SPECTROSCOPIC ELLIPSOMETER  │
└──────────────┬───────────────────┘
               │
               ▼
┌────────────────────────────────────────┐
│ DETERMINE EFFECTIVE FILM THICKNESS      │──S12
│ THROUGH FITTING OF THEORETICAL          │
│ DIELECTRIC FUNCTION TO MEASURED         │
│ DIELECTRIC FUNCTION                     │
└──────────────────┬─────────────────────┘
                   │
                   ▼
┌────────────────────────────────────────┐
│ DETERMINE VALUES OF GROUP OF PARAMETERS │──S13
│ REPRESENTING SHAPE OF SILICON FILM      │
└──────────────────┬─────────────────────┘
                   │
                   ▼
        ┌─────────────┐
        │     END     │
        └─────────────┘
```

FIG. 9

EP 2 682 712 A1

<table>
<tr><td colspan="2" align="center">INTERNATIONAL SEARCH REPORT</td><td>International application No.<br>PCT/JP2011/072220</td></tr>
</table>

A. CLASSIFICATION OF SUBJECT MATTER
*G01B11/24*(2006.01)i, *G01N21/21*(2006.01)i, *H01L31/04*(2006.01)i

According to International Patent Classification (IPC) or to both national classification and IPC

B. FIELDS SEARCHED

Minimum documentation searched (classification system followed by classification symbols)
G01B11/24, G01N21/21, H01L31/04

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho    1971-2011   Toroku Jitsuyo Shinan Koho   1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | Nobuyuki MATSUMOTO, Yoshikazu TANAKA, Hiroyuki FUJIWARA, "Bunko Ellipsometry ni yoru Texture-gata a-Si:H/c-Si Hetero Setsugo Taiyo Denchi no Koseido Kozo Hyoka", Dai 71 Kai Extended abstracts; the Japan Society of Applied Physics, 2001 Nen Aki, 15a-ZB-6 | 1-10 |
| A | JP 2010-60388 A (Tokyo Electron Ltd.), 18 March 2010 (18.03.2010), paragraphs [0077] to [0104], [0192] to [0208]; fig. 4, 18 to 20 (Family: none) | 1-10 |

[X] Further documents are listed in the continuation of Box C.       [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
02 November, 2011 (02.11.11)

Date of mailing of the international search report
15 November, 2011 (15.11.11)

Name and mailing address of the ISA/
Japanese Patent Office

Authorized officer

Facsimile No.

Telephone No.

Form PCT/ISA/210 (second sheet) (July 2009)

21

**EP 2 682 712 A1**

**INTERNATIONAL SEARCH REPORT**

International application No.

PCT/JP2011/072220

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-208531 A  (Oki Electric Industry Co., Ltd.), 03 August 2001 (03.08.2001), paragraphs [0005] to [0013]; fig. 1, 2 & US 6349594 B1 | 1-10 |
| A | JP 2004-536314 A  (Therma-Wave, Inc.), 02 December 2004 (02.12.2004), paragraphs [0014] to [0018], [0028]; fig. 1, 2 & US 6704661 B1        & EP 1410110 A & WO 2003/009063 A2 | 1-10 |

Form PCT/ISA/210 (continuation of second sheet) (July 2009)

22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004157060 A